Europäisches Patentamt

European Patent Office

Office européen des brevets

(11) Publication number: **0 211 350**
**A2**

## (12) EUROPEAN PATENT APPLICATION

(21) Application number: 86110277.0

(51) Int. Cl.⁴: **G03F 7/08** , G03F 7/26

(22) Date of filing: 25.07.86

(30) Priority: 07.08.85 US 763176

(43) Date of publication of application:
25.02.87 Bulletin 87/09

(84) Designated Contracting States:
DE FR GB IT

(71) Applicant: **International Business Machines**
**Corporation**
**Old Orchard Road**
**Armonk, N.Y. 10504(US)**

(72) Inventor: **Chiong, Kaolin N.**
**46 Heritage Drive**
**Pleasantville New York 10570(US)**
Inventor: **Chow, Ming-Fea**
**Beyer Drive**
**Poughquagh New York 10570(US)**
Inventor: **Green, Dennis Clinton**
**RD 9, Box 257 Saddle Ridge Drive**
**Hopewell Junction New York 12533(US)**
Inventor: **Miller, Robert Dennis**
**6614 Tam O'Shanter Drive**
**San Jose California 95120(US)**
Inventor: **Skinner, Michael Patrick**
**9 Gertrude Plase**
**Wappingers Falls New York 12590(US)**
Inventor: **Willson, Carlton Grant**
**1982 University Avenue**
**San Jose California 95126(US)**

(74) Representative: **Oechssler, Dietrich,**
**Dr.rer.nat. Dipl.-Chem.**
**Schönaicher Strasse 220**
**D-7030 Böblingen(DE)**

(54) Photoresist composition and method of applying same.

(57) The photoresist composition is comprised of an admixture of a phenol-formaldehyde type resin, a diazoquinone sensitizer and an organic base wherein the organic base comprises at least one nitrogen moiety present within a ring structure, and wherein the at least one nitrogen moiety is part of a conjugated system having at least three double bonds.

To create a negative tone photoresist pattern on a substrate the photoresist composition is applied to a substrate; a latent image is created by imagewise irradiating said resist; the imaged photoresist is heated to render the exposed areas insoluble in alkaline developer; said imaged photoresist is subsequently blanket exposed to actinic radiation, after which the singly exposed areas of the photoresist are removed with an alkaline developer.

The photoresist composition has an increased shelf life and permits image reversal under typical process conditions.

## Photoresist Composition and Method of Applying Same

Photosensitive materials play an important part in the fabrication of large scale integrated circuits. Such materials permit circuit designers to create patterns of micron and submicron dimensions upon substrate materials such as silicon and silicon oxides. The patterns are created by means of a photolithographic process, wherein a photoresist material is applied to the substrate, the photoresist is exposed to imaging radiation to create a latent image therein, and subsequently the latent image is developed into a patterned resist using either a wet or dry development process. The photoresist material itself may be the patterned material to be created upon the substrate, or it may provide a mask for subsequent processing such as the deposition of a different material upon exposed areas of the substrate not protected by the masking layer. The photoresist may be applied over a layer of a different material so that the photoresist can be used as a mask during a process which permits transfer of the pattern from the photoresist to the adjacent layer of the different material.

A distinction is made between positive tone and negative tone photoresists. The term positive tone photoresist is used to describe a material which upon exposure to a given radiation (such as actinic radiation, electron beam, ion beam, or X-ray) is chemically or structurally altered so that upon development of the latent image, the exposed areas of the photoresist are removed. The term negative tone photoresist is used to describe a material which upon exposure to radiation is chemically or structurally altered so that upon development of the latent image, the unexposed areas of the photoresist are removed.

Processes of image reversal are well known in the art. In such a process, a normally positive working photoresist can be used to produce a negative tone pattern. There are several published methods of accomplishing this kind of image reversal. Perhaps the best known method is described in U.S. Patent 4,104,070 to Moritz et al., wherein a layer of positive photoresist is applied to a substrate (the positive photoresist is comprised of a phenolformaldehyde resin, a napthoquinone (1,2) diazide sulfonic acid ester sensitizer, and a hydroxyethyl-2-alkylimidazoline base); the photoresist layer is imagewise exposed to actinic radiation; the composite substrate and photoresist layer is subjected to heat for a sufficient period of time to react the indene carboxylic acid groups - (created within the photoresist upon exposure to actinic radiation) with the imidazoline base, thus rendering the portion of the photoresist exposed to actinic radiation insoluble in alkaline developer;

subsequently, the surface of the photoresist is exposed to blanket actinic radiation; and then the portions of the photoresist which were not imagewise exposed to actinic radiation (but which were exposed to the blanket actinic radiation) are removed using an alkaline developer. A disadvantage of using this process is the decreased shelf life of the positive photoresist material which results from the presence of the hydroxyethyl-2-alkylimidazoline base. This basic additive, which is used to obtain image reversal, also catalyzes side reactions which increase the viscosity of the resist and can cause fairly severe degradation in photosensitivity of the resist. U.S. Patent 4,104,078 is hereby incorporated by reference, since the present invention is viewed as an improvement over the invention disclosed therein.

Additional description of the image reversal method, wherein an organic base is added to the photoresist in order to obtain the image reversal capability is presented in "IMAGE REVERSAL: THE PRODUCTION OF A NEGATIVE IMAGE IN A POSITIVE PHOTORESIST", S. A. MacDonald et al., Kodak Microelectronics Seminar Proceedings pp.114-117, from San Diego 1982. The MacDonald et al. publication is also incorporated by reference, since the present invention is viewed as an improvement over the method described therein.

A different method of obtaining image reversal is described in "IMAGE REVERSAL LIFT-OFF PROCESS", C. J. Hamel et al., IBM Technical Disclosure Bulletin, Vol. 24, No. 10 (March 1982) p. 5063. This method accomplishes image reversal by causing dicarboxylation of the photoactive compound decomposition products as do the methods previously described, but the decarboxylation is achieved by subjecting the image-exposed photoresist to a basic environment such as gaseous ammonia. An additional description of the use of a basic environment to achieve decarboxylation appears in "Lithography Trends", Burggraaf, Sr. Editor, Semiconductor International, December l984, pp. 35-36. The method disclosed in this publication utilizes the alkali-soluble novolak resins combined with o-quinone diazide sensitizers as the photoresist material; however, no base (such as the hydroxyethyl-2-alkylimidazoline described above) is used as a part of the photoresist composition. After the imagewise exposure to actinic radiation, the photoresist is treated using an amine vapor to render the indene carboxylic acid, formed upon exposure of the photoresist to actinic radiation, insoluble to alkali solutions and insensitive to further ultraviolet exposure. Some of the disadvantanges of using the gaseous ammonia/amine vapor process include the time required for the vapor to diffuse into the photoresist and the corrosive effect of the vapor on process equipment.

It is the object of the invention to provide a photoresist composition for image reversal having an increased stability under storage condition and a reproducible application of said composition.

This object is achieved by photoresist compositions as claimed in claims 1 and 8 and by a method as claimed in claim 9. The inventive photoresist composition not only provides an increased shelf life but also permits image reversal under typical process conditions. It is preferable to have the nitrogen moiety of the organic base be sterically protected as well as stable in terms of electronic configuration. Examples of organic bases of the type disclosed in the present invention, which can be used in photoresist compositions to obtain image reversal, include (but are not limited to) 2,6-di-t-butylpyridine, benzimidazole, pyridine, quinoline, acridine, lutidine, and 1-methyl benzimidazole. Organic bases of this type can be substituted for the 1-hydroxyethyl-2-alkylimidazoline disclosed in the U.S. Patent to Moritz et.al. (Assigned to the assignee of the present invention) in order to obtain image reversal while providing increased shelf life for the photoresist composition.

Other advantageous embodiments of the inventive composition are disclosed in the subclaims.

The invention will become more apparent from the following description taken in conjunction with the accompanying figure. It shows:

FIG.1 the imidazoline derivative used by Moritz at al.

FIGS.2 and 3 additional organic bases which did not provide adequate shelf life and

FIGS.4 to 11 organic bases suitable for the inventive composition.

The present invention is described below in detail in terms of specific examples.

EXAMPLE I

Accelerated Shelf Life Testing

The photoresist comprised a mixture of a cresol formaldehyde novolak resin, a diazoquinone sensitizer and an organic base selected from those specified in the table below. The admixture was created by placing the photoresist ingredients into a casting solution using a mixture of ethyl cellosolve acetate: n-butylacetate (90:10 by weight) as the solvent.

The concentrations of solution components were as follows: The cresol formaldehyde novolak resin comprised about 30% by weight of the solution; and The diazoquinone sensitizer comprised about 5% by weight of the solution; The organic base comprised about 1 mole% of the solution; and the ethyl cellosolve acetate: n-butylacetate - (90:10) solvent comprised about 65% by weight of the solution.

Note that the casting solution solvent can be comprised of any of the individual or mixtures of solvents cited in the literature for use in combination with diazoquinone/novolak resists.

The storage temperature was approximately 40°C, and the storage time period was as shown in Table I.

TABLE I

| ORGANIC BASE | TIME (days) | VISCOSITY INCREASE (%) | BASE $pK_a$ | COLOR |
|---|---|---|---|---|
| N,N-diisopropyl-ethylamine | 1 | 78 | 11.0 | Opaque/ Black |
| 1-hydroxyethyl-2-alkylimidazoline | 3 | <14* | <8 | Opaque/ Black |
| Imidizole | 3 | 14 | 7.0 | Opaque/ Black |
| 2-methyl-benzimidazole | 3 | 5 | 6.2 | Clear/ Dk.Red |
| 3,5 lutidine | 3 | 13 | 6.2 | Clear/ Dk.Red |
| 2,6,Lutidine | 3 | 6 | 6.0 | Clear/ Md.Red |
| 2,6-di-t-butyl-pyridine | 5 | 0 | 6.0 | Clear/ Lt.Red |
| Acridine | 3 | 6 | 5.6 | Clear/ Md.Red |
| Benzimidazole | 3 | 3 | 5.5 | Clear/ Md.Red |
| Pyridine | 3 | --- | 5.2 | Clear/ Lt.Red |
| Quinoline | 3 | 5 | 4.9 | Clear/ Lt.Red |

*   Rapid degradation - viscosity change note measured accurately

< = greater than

Review of the above table shows that the materials which do not exhibit the preferred structure - (wherein the ring structure containing the at least one nitrogen moiety exhibits alternating double bonds, or wherein the ring structure containing the at least one nitrogen moiety does not exhibit alternating double bonds exclusively, but is adjacent to at least one ring structure which does exhibit alternating double bonds exclusively and wherein the at least one nitrogen moiety is connected to the at least one adjacent ring structure in a manner which continues the alternating double bond configuration) show a significant increase in viscosity within as little as one day. The viscosity increase is accompanied by a darkening in color and opacification of the photoresist solution.

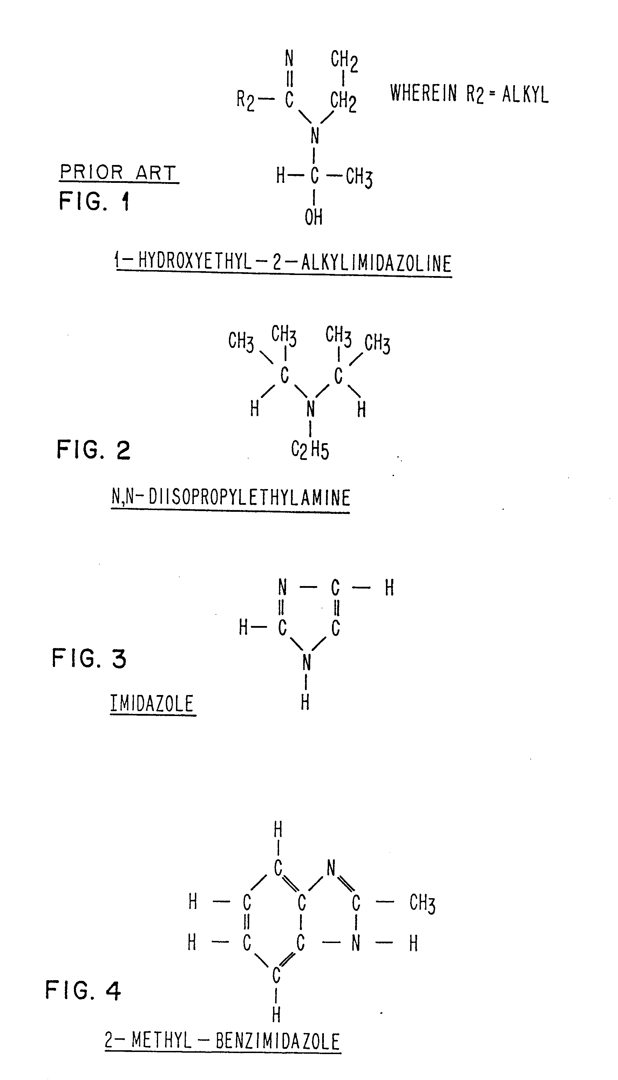

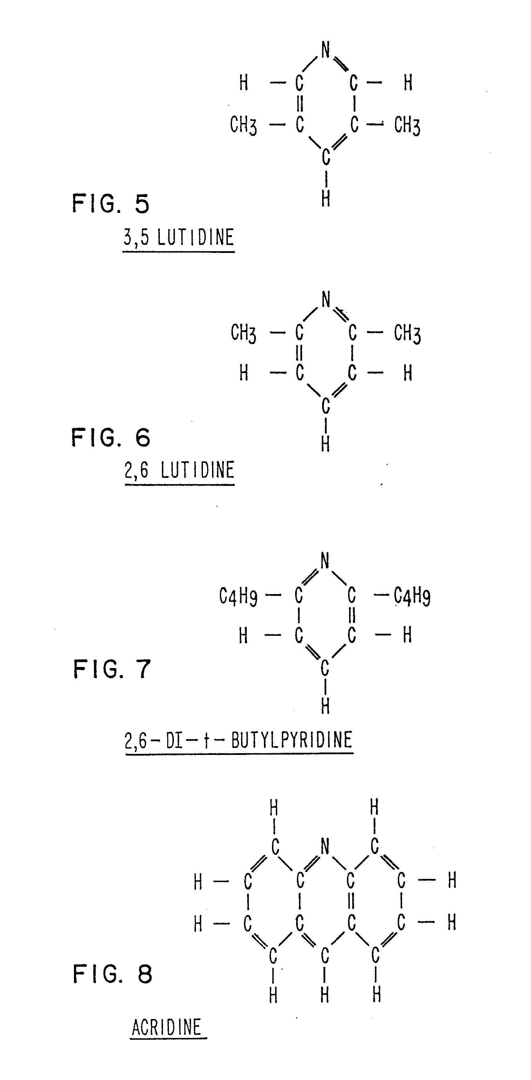

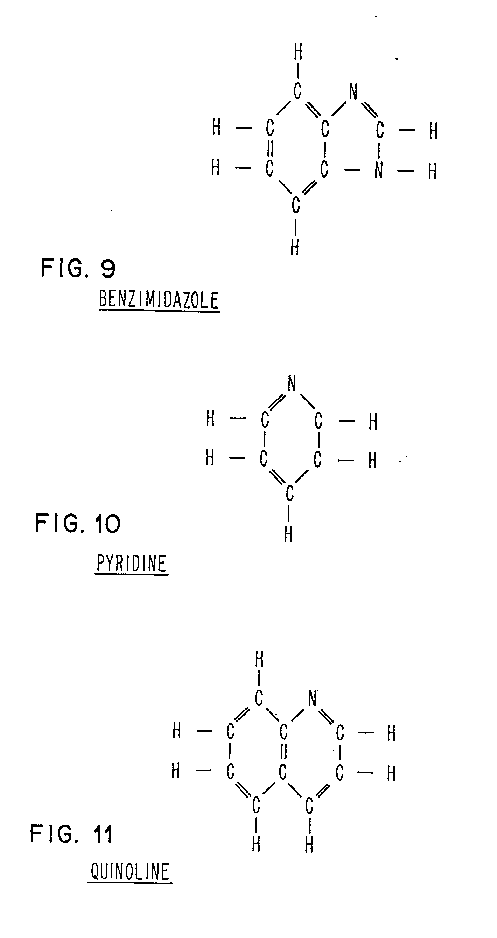

The structures of the example materials described above are shown in FIGS. 1-11 for purposes of comparison. The 1-hydroxyethyl-2-alkylimidazoline of Moritz et al. is shown in FIG. 1 and additional structures which did not provide adequate shelf life are shown in FIGS. 2 and 3. FIGS. 4-11 show examples of the types of structures which provide an organic base which can be used within the image reversal process in order to obtain increased shelf life of the photoresist solution. Given two very similar structures, the most preferred is that wherein the nitrogen moiety is sterically protected in order to reduce the degree of undesirable side reactions taking place. For example, the structure of FIG. 7 is preferred over the structure of FIG. 10, and the structure of FIG. 6 is preferred over the structure of FIG. 5. The most preferred structure of those shown in FIGS. 4-11 is the benzimidazole of FIG.9. This material is relatively non-toxic and exhibits a sufficiently low vapor pressure to remain in the photoresist film at process temperatures. In addition, the benzimidazole provides a nice balance between the competing factors of longer shelf stability and the reactivity desired during the decarboxylation step required to achieve image reversal.

## EXAMPLE II

The image-reversible photoresist solution comprised an admixture of about 30 weight % of a novolak_resin, about 5 weight % of a diazoquinone photosensitizer, about 2 weight % of about (1 mole %) benzimidazole organic base, and about 63 weight % of ethyl cellosolve acetate: n-butylacetate (90:10) solvent.

A thin photoresist film was applied onto a silicon wafer covered with a thermally produced silicon dioxide layer, by means of a standard spin coating technique. The photoresist film was then dried for about 20 minutes at about 80°C.

The photoresist film was then imagewise exposed to actinic radiation through a BLM mask, using a commercially available reflective scan projection exposure tool in order to create a latent image within the photoresist film.

The image-wise exposed photoresist film was then heated to about 100°C for a period of about 30 minutes in order to react the organic base with the indene carboxylic acid groups which were formed within the irradiated portions of the photoresist upon irradiation.

After the above thermal treatment, the photoresist film was blanket exposed to broadband actinic radiation in order to create the indene carboxylic acid groups within the previously unexposed portions of the photoresist. No major change occurred within the image-wise exposed and reacted areas of the photoresist.

In accordance with standard technology, the photoresist material was developed using an alkaline developer to produce the desired negative pattern (the portions of the photoresist remaining after development were the image-wise irradiated and reacted portions). The developed patterns comprised line widths of about 2 micrometers at line spacings of about 2 micrometers, wherein the height of the wall of the photoresist above the substrate was about 3 micrometers, and the wall profile ranged from relatively straight to slightly undercut, depending on the length of the development time.

## EXAMPLE III

For purposes of comparison, the procedure of EXAMPLE II was repeated wherein the ingredients comprising the photoresist and their concentration remained about the same, except that the organic base was comprised of imidizole (an organic base not capable of providing long shelf life; structure shown in FIG.3).

The developed photoresist patterns comprised line widths of about 2 micrometers at line spacings of about 2 micrometers, wherein the height of the wall of the photoresist above the substrate was about 3 micrometers and the wall profile ranged from relatively straight to slightly undercut, depending on the length of the development time.

While specific embodiments of the present invention are defined in Examples I to III above, there are additional organic bases which meet the chemical and structural requirements which enable them to function within the present invention. These organic bases will be brought to the mind of those skilled in the art upon reading of the present disclosure, and are intended to be included herein.

## Claims

1. Photoresist composition comprised of an admixture of a phenol-formaldehyde type resin, and an organic base, wherein the organic base comprises at least one nitrogen moiety present within a ring structure, and wherein said ring structure is selected from the group consisting of ring structures in which the entire ring containing said at least one nitrogen moiety exhibits alternating double bonds, and ring structures in which the ring containing said at least one nitrogen moiety does not exhibit alternating double bonds exclusively, but is adjacent to ring structures which do exhibit said double bonds exclusively and wherein said at least one nitrogen moiety is connected to said adjacent ring structure in a manner which continues the alternating double bond configuration.

2. Photoresist composition according to claim 1, wherein said resin is contained in sufficient quantity amount when combined with a diazoquinone sensitizer to be developable to form a positive image, wherein said diazoquinone sensitizer is contained in sufficient amount to function as the photoactive component in an electron beam, X-ray, or optical exposure process, and wherein said organic base is contained in sufficient amount to react with the carboxylic acid functional groups formed during the exposure process so that the exposed photoresist becomes insoluble in standard alkaline developers.

3. Photoresist composition according to claim 1 or 2 wherein the $pK_a$ of said organic base ranges from about 5.0 to about 6.5.

4. Photoresist composition according to any one of claims 1 to 3 wherein said at least one nitrogen moiety is sterically protected.

5. Photoresist composition according to any one of claims 1 to 4 wherein said organic base is selected from the group consisting of benzimidazole, 2-methyl-benzimidazole, 2,6-di-t-butylpyridine, pyridine, quinoline, 2,6-lutadine, 3,5-lutadine, and acridine.

6. Photoresist composition according to any one of claims 1 to 5 including a suitable solvent for placing the ingredients of said admixture into a casting/coating solution of the type used in the lithographic industry.

7. Photoresist composition according to any one of claims 1 to 6 wherein the composition contains about 30 % by weight of said resin, about 5 % by weight of said sensitizer, about 63 % of the solvent, preferably a mixture of ethyl cellosolve acetate and n-butylacetate (weight ratio 90:10) and about 1 mole-% of said organic base.

8. Photoresist composition comprised of an admixture of a phenol-formaldehyde type resin, a diazoquinone sensitizer and an organic base wherein the organic base comprises at least one nitrogen moiety present within a ring structure, and wherein the at least one nitrogen moiety is part of a conjugated system having at least three double bonds.

9. A method of creating a negative tone photoresist pattern on a substrate, wherein a photoresist composition according to any one of claims 1 to 8 is applied to a substrate; a latent image is created within said applied photoresist composition by imagewise exposing said resist to actinic radiation; the imaged photoresist composition is heated to a sufficient temperature for a sufficient time period to render the exposed areas insoluble in alkaline developer; said imaged photoresist composition is subsequently blanket exposed to actinic radiation, after which the singly exposed areas of the photoresist are removed with an alkaline developer.

WHEREIN R2 = ALKYL

PRIOR ART
## FIG. 1

1-HYDROXYETHYL-2-ALKYLIMIDAZOLINE

## FIG. 2

N,N-DIISOPROPYLETHYLAMINE

## FIG. 3

IMIDAZOLE

## FIG. 4

2-METHYL-BENZIMIDAZOLE

FIG. 5

3,5 LUTIDINE

FIG. 6

2,6 LUTIDINE

FIG. 7

2,6 − DI − t − BUTYLPYRIDINE

FIG. 8

ACRIDINE

## FIG. 9

BENZIMIDAZOLE

## FIG. 10

PYRIDINE

## FIG. 11

QUINOLINE